# EUROPEAN PATENT APPLICATION

(11) **EP 4 156 187 A1**
(43) Date of publication of application: **29.03.2023**
(21) Application number: 21916637.8
(22) Date of filing: 18.09.2021
(51) Int. Cl.: G11C 11/4063, H01L 27/108

(54) **SEMICONDUCTOR STRUCTURE AND LAYOUT THEREOF, AND SEMICONDUCTOR DEVICE**

(30) Priority: 10.08.2021 CN 202110915940
(71) Applicant: Changxin Memory Technologies, Inc., Hefei City, Anhui 230000 (CN)
(72) Inventor: WANG, Peihuan, Hefei, Anhui 230000 (CN)
(74) Representative: Lavoix
(86) International application number: PCT/CN2021/119422
(87) International publication number: WO 2023/015678

(57) **Abstract**

The disclosure provides a semiconductor structure, a layout of the semiconductor structure and a semiconductor device. The semiconductor structure includes: a plurality of first conductive layers that are spaced; a plurality of capacitor banks, and the capacitor bank being on the first conductive layer in one-to-one correspondence and the capacitor bank including at least a capacitor, each capacitor including a lower electrode layer, a capacitance dielectric layer and an upper electrode layer stacked from bottom to top; a capacitor plate, wherein the capacitor plate is on each upper electrode layer; and a second conductive layer, wherein the second conductive layer is above the capacitor plate and connected with the capacitor plate. In the above semiconductor structure, the second conductive layer is formed above the capacitor plate, and the second conductive layer is connected with the capacitor plate, so that in the semiconductor structure, the second conductive layer is equivalent to being connected in parallel at two ends of the capacitor plate, that is, the second conductive layer is connected with the capacitor plate in parallel, and the resistance formed by the parallel connection of the second conductive layer and the capacitor plate is lower than the resistance of the capacitor plate itself, thereby avoiding the problem of affecting the performance due to the high resistance and improving the performance of the semiconductor structure.

## Description

### Cross-Reference to Related Application

The disclosure takes the patent document No. 202110915940.3, filed on August 10, 2021 and entitled " Semiconductor Structure, Layout of Semiconductor Structure and Semiconductor Device " as the priority document, the disclosure of which is hereby incorporated by reference in its entirety.

### Technical Field

The disclosure relates to the field of semiconductors, in particular to a semiconductor structure a layout of the semiconductor structure and a semiconductor device.

### Background

Inventors found that, a capacitor plate is usually set on a capacitor, but a resistance of the capacitor plate is high at present, and reaches 50 ohms in some memories, which seriously affects performance of a structure.

At present, there is no effective solution to a problem of high resistance of semiconductor devices due to the high resistance of the capacitor plate on the capacitor.

The above information disclosed in the background is only used to enhance understanding of the background art of the technology described herein; therefore, the background art can include some information that does not form known conventional art in the country for those skilled in the art.

### Summary

The main purpose of the disclosure is to provide a semiconductor structure, a layout of the semiconductor structure and a semiconductor device, so as to improve the performance of a semiconductor structure.

For this purpose, according to an aspect of the disclosure, a semiconductor structure is provided, the semiconductor structure includes: a plurality of first conductive layers that are spaced; a plurality of capacitor banks, and the capacitor bank being on the first conductive layer in one-to-one correspondence and the capacitor bank including at least a capacitor, each capacitor including a lower electrode layer, a capacitance dielectric layer and an upper electrode layer stacked from bottom to top; a capacitor plate, wherein the capacitor plate is on each upper electrode layer; and a second conductive layer, wherein the second conductive layer is above the capacitor plate and connected with the capacitor plate.

According to another aspect of the disclosure, a layout of a semiconductor structure is provided, the layout include: a plurality of first conductive layer patterns that are set intervals; a plurality of capacitor bank patterns, and the capacitor bank pattern being on the first conductive layer pattern in one-to-one correspondence, the capacitor bank pattern including at least a capacitor pattern; a capacitor plate pattern, wherein the capacitor plate pattern is overlaid on each of the plurality of the capacitor bank patterns; and a second conductive layer pattern, wherein the second conductive layer pattern is overlaid on at least a part of the capacitor plate pattern.

According to yet another aspect of the disclosure, a semiconductor device is provided, the semiconductor device include any one of the semiconductor structures; or the layout of the semiconductor device include any one of the layout of the semiconductor structures.

By the technical solutions of the disclosure, in the above semiconductor structure, the second conductive layer is formed above the capacitor plate, and the second conductive layer is connected with the capacitor plate, so that in the semiconductor structure, the second conductive layer is equivalent to being connected in parallel at two ends of the capacitor plate, that is, the second conductive layer is connected with the capacitor plate in parallel, and the resistance formed by the parallel connection of the second conductive layer and the capacitor plate is lower than the resistance of the capacitor plate itself. Therefore, compared to the semiconductor structure without the second conductive layer, the resistance of the semiconductor structure with the second conductive layer is low, thereby avoiding the problem of affecting the performance due to the high resistance and improving the performance of the semiconductor structure.

### Brief Description of the Drawings

The accompanying drawings constituting a part of the disclosure are used for providing further understanding of the disclosure. Schematic embodiments of the disclosure and description thereof are used for illustrating the disclosure and not intended to form an improper limit to the disclosure. In the accompanying drawings:
Fig. 1 is a structure diagram of an embodiment of a semiconductor structure according to the disclosure;
Fig. 2 is an equivalent circuit diagram of an embodiment of the semiconductor structure in Fig. 1;
Fig. 3 is a structure diagram of an embodiment of a semiconductor structure according to the disclosure;
Fig. 4 is a schematic diagram of an embodiment of a layout of a semiconductor structure according to the disclosure;
Fig. 5 is a structure diagram of a charge pump including a semiconductor structure;
Fig. 6 is a schematic layout diagram of a comparison embodiment of a semiconductor structure according to the disclosure;
Fig. 7 is a structure diagram of a comparison embodiment of a semiconductor structure according to the disclosure; and
Fig. 8 is an equivalent circuit diagram of an embodiment of the semiconductor structure in Fig. 7.

### The above accompanying drawings include the following reference numbers:

10, first conductive layer; 20, capacitor bank; 21, capacitor; 30, capacitor plate; 31, first part; 32, second part; 33, third part; 40, first contact via; 50, second conductive layer; 60, second contact via; 100, first conductive layer pattern; 200, capacitor bank pattern; 201, capacitor pattern; 300, capacitor plate pattern; 400, first contact via pattern; 500, second conductive layer pattern; 600, second contact via pattern.

### Detailed Description of the Embodiments

It should be noted that the following detailed description is illustrative and is intended to provide a further description of the disclosure. Unless otherwise indicated, all technical and scientific terms used herein have the same meaning as that commonly understood by those of ordinary skill in the art to which the disclosure belongs.

It is to be noted that terms used herein are only to describe specific embodiments, and are not intended to limit the exemplary embodiments of the disclosure. As used herein, unless otherwise explicitly indicated in the context, a singular form is also intended to include a plural form. In addition, it is also to be understood that when the terms "include" and/or "have" are used in the description, they are intended to indicate the presence of features, steps, operations, devices, components, and/or combinations thereof.

It is to be understood that when a component (such as a layer, a film, an area, or a substrate) is described as being "on" another component, this component can be directly on the another component, or there can be an intermediate component. Further, in the specification and the claims, when a component is described as being "connected" to another component, this component can be "directly connected" to the another component or "connected" to the other component through a third component.

As introduced in the background, in a semiconductor structure including a capacitor in the conventional art, the resistance of a capacitor plate on the capacitor is large, so the resistance of the semiconductor structure is large, which affects the performance of the semiconductor structure. In order to solve the above technical problem, the disclosure presents a semiconductor structure, a layout of the semiconductor structure and a semiconductor device.

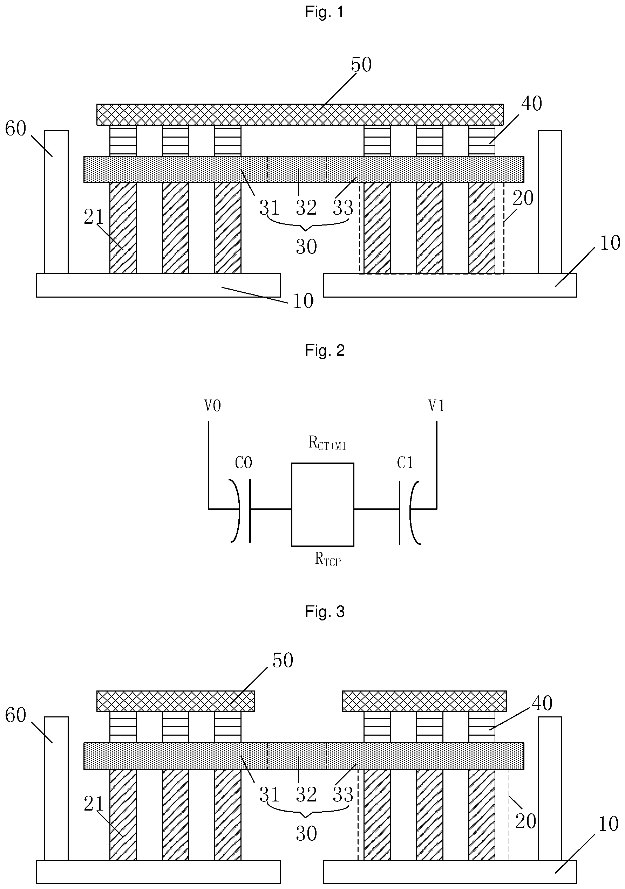

In a typical implementation mode of the disclosure, a semiconductor structure is provided. As shown in Fig. 1, the semiconductor structure includes a plurality of first conductive layers 10 which are spaced, a plurality of capacitor banks 20, a capacitor plate 30 and a second conductive layer 50. The plurality of the capacitor banks 20 are on the plurality of first conductive layers 10 in one-to-one correspondence. The capacitor bank 20 includes at least a capacitor 21. Each capacitor 21 includes a lower electrode layer, a capacitance dielectric layer and an upper electrode layer stacked from bottom to top, that is, the lower electrode layer is on the first conductive layer 10, the capacitance dielectric layer is on the lower electrode layer, and the upper electrode layer is on the capacitance dielectric layer. The specific structure of the capacitor bank 20 is not shown in the figure. The capacitor plate 30 is on each upper electrode layer, that is, the plurality of the capacitor banks are actually connected in series. The second conductive layer 50 is above the capacitor plate 30 and connected with the capacitor plate 30.

In the above semiconductor structure, the second conductive layer 50 is formed above the capacitor plate 30, and the second conductive layer 50 is connected with the capacitor plate 30, so that in the semiconductor structure, the second conductive layer 50 is equivalent to being connected in parallel at two ends of the capacitor plate 30, that is, the second conductive layer 50 is connected with the capacitor plate 30 in parallel, and the resistance formed by the parallel connection of the second conductive layer and the capacitor plate is lower than the resistance of the capacitor plate 30 itself. Therefore, compared to the semiconductor structure without the second conductive layer 50, the resistance of the semiconductor structure with the second conductive layer 50 is low, thereby avoiding the problem of affecting the performance due to the high resistance and improving the performance of the semiconductor structure.

As shown in Fig. 1, in a specific embodiment of the disclosure, the semiconductor structure further includes a first contact via 40, which is between the capacitor plate 30 and the second conductive layer 50, and is used for connecting the capacitor plate 30 and the second conductive layer 50. The second conductive layer 50 and the capacitor plate 30 can be more conveniently connected through the first contact via 40. The equivalent circuit diagram of the structure is shown in Fig. 2. It can be seen from Fig. 2 that the resistance of the part formed by the capacitor plate 30, the second conductive layer 50 and the first contact via 40 meets Rₜₒₜₐₗ=R_{CT+M1}//R_{TCP}, and R_{TCP} is the resistance of the capacitor plate 30, R_{CT+M1} is the resistance of the second conductive layer 50 and the first contact via 40, and Rₜₒₜₐₗ is the equivalent resistance of the capacitor plate 30 and the second conductive layer 50 connected in parallel. Therefore, compared to the semiconductor structure without the second conductive layer 50, the resistance in the structure is still low.

The materials of the first contact via in the disclosure are conductive materials, which can be selected according to the actual situation, including but not limited to wolfram (W), cuprum (Cu), nickel (Ni), aurum (Au) or argentum (Ag), etc.

Specifically, the number of the first contact vias can be set according to the area of the second conductive layer, etc. There can be a plurality of the first contact vias, and there can also be one first contact via. For example, when the area of the second conductive layer is large, the number of the first contact vias can be set to be larger; when the area of the second conductive layer is small, the number of the first contact vias can be set to be small correspondingly. The larger the number of the first contact vias, the lower the overall equivalent resistance, and the lower the equivalent resistance of the capacitor plate 30 and the second conductive layer 50 connected in parallel.

In order to connect the second conductive layer 50 and the capacitor plate 30 better, and stably support the second conductive layer 50, as shown in Fig. 1, in a specific embodiment of the disclosure, there are a plurality of the first contact vias 40, and the plurality of the first contact vias 40 are set intervals.

There can be one second conductive layer 50, as shown in Fig. 1; in this case, the area of the second conductive layer 50 is approximately equal to that of the capacitor plate 30 (actually the area of the second conductive layer is slightly smaller).

Of course, there can be a plurality of the second conductive layers 50. In an embodiment of the disclosure, as shown in Fig. 3, there are a plurality of the second conductive layers 50, and the plurality of the second conductive layers 50 are set intervals in a predetermined direction which is perpendicular to the thickness direction of the first conductive layer 10. In this case, the sum of the areas of all of the plurality of the second conductive layers 50 can be approximately equal to the area of the capacitor plate 30.

It is also to be noted that when there is one second conductive layer, the second conductive layer can be formed by one or a plurality of metal materials. When the second conductive layer is formed by the plurality of the metal materials, the plurality of the metal materials can be mixed to form a single layer, or can form a metal layer separately, and the plurality of the metal materials form a plurality of the metal layers, and the plurality of the metal layers are superimposed to form the second conductive layer. When there are the plurality of the second conductive layers, the materials and thicknesses of the plurality of the second conductive layers can be the same or different. When the thicknesses are different, the height of the first contact via can also be adjusted. In addition, the specific material setting of each of the plurality of the second conductive layers can be seen in the case of one second conductive layer, which will not be described here.

In another embodiment of the disclosure, the material of the first conductive layer of the disclosure can be metal, that is, the first conductive layer is a metal layer. The top of the first conductive layer is connected with the bottom of the lower electrode layer.

The lower electrode layer of the disclosure can include conductive compounds formed by one or two of metal nitrides and metal silicides, such as Titanium Nitride, Titanium Silicide, Nickel Silicide, and TiSixNy. In a specific embodiment of the disclosure, the lower electrode layer includes a titanium nitride layer formed by Atomic Layer Deposition (ALD).

The capacitance dielectric layer of the disclosure can be a high K dielectric layer, so as to improve the capacitance value per unit area, and can include a layer stack formed by nitrides or one of ZrOx, HfOx, ZrTiOx, RuOx, SbOx and AlOx or more than two of the group of the above materials.

The upper electrode layer of the disclosure can include compounds formed by one or two of metal nitrides and metal silicides, such as Titanium Nitride, Titanium Silicide, Nickel Silicide, and TiSixNy. In a specific embodiment, the upper electrode layer include a titanium nitride layer formed by ALD.

It is to be noted that the materials of the second conductive layer and the first conductive layer in the disclosure can include, but are not limited to, wolfram (W), cuprum (Cu), nickel (Ni), aurum (Au) or argentum (Ag), etc. The materials of the second conductive layer and the first conductive layer can be the same or different, and those skilled in the art can choose the suitable material according to the actual situation.

The capacitor plate of the disclosure is a conductive layer, which can include conductive materials and semiconductor materials, such as Si and/or Ge. Suitable materials can be selected according to the actual situation to form the capacitor plate 30 of the disclosure.

In a specific embodiment, as shown in Fig. 1, the semiconductor structure of the disclosure also includes a second contact via 60, which is on the first conductive layer 10 and outside a predetermined area of the capacitor plate. The predetermined area is an area, in which the capacitor bank is set, of the first conductive layer.

The material of the second contact via is a conductive material, which can be selected according to the actual situation, including but not limited to wolfram (W), cuprum (Cu), nickel (Ni), aurum (Au) or argentum (Ag), etc.

In a specific embodiment of the disclosure, there are a plurality of the second contact vias 60. In the specific design process, one or more second contact vias can be set according to the actual situation, and the specific position can also be adjusted according to the actual situation.

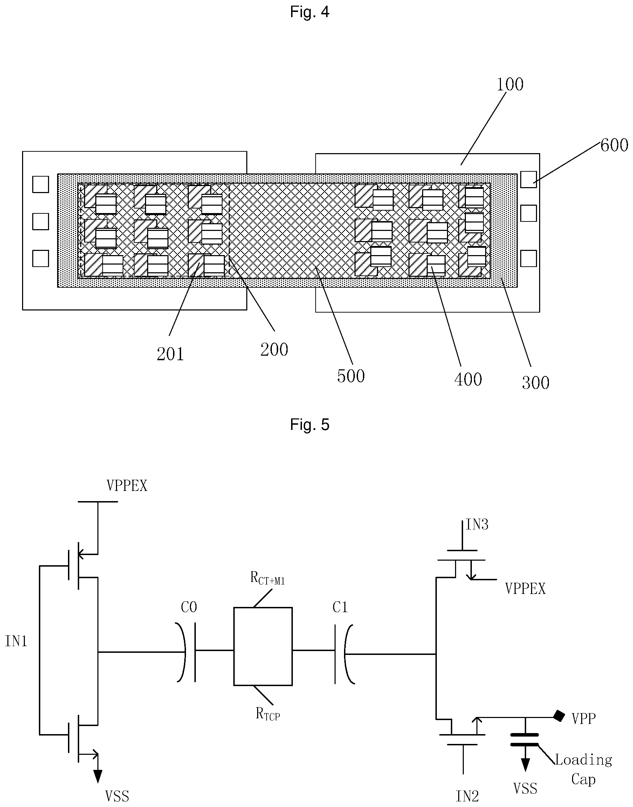

In another typical implementation mode of the disclosure, a layout of a semiconductor structure is provided. As shown in Fig. 4, the layout includes a plurality of first conductive layer patterns 100 which are set intervals, a plurality of capacitor bank patterns 200, a capacitor plate pattern 300 and a second conductive layer pattern 500. The capacitor bank pattern 200 is on the first conductive layer pattern 100 in one-to-one correspondence. The capacitor bank pattern 200 includes at least a capacitor pattern 201. The capacitor plate pattern 300 is overlaid on each of the plurality of the capacitor bank patterns 200. The second conductive layer pattern 500 is overlaid on at least a part of the capacitor plate pattern 300.

In the layout of the semiconductor structure, the second conductive pattern is on the capacitor plate pattern, so that the second conductive layer is formed correspondingly on the capacitor plate in the semiconductor structure corresponding to the layout, that is, the second conductive layer connected with the capacitor plate is formed; the second conductive layer is equivalent to being connected in parallel at two ends of the capacitor plate, that is, the second conductive layer is connected with the capacitor plate in parallel, and the resistance formed by the parallel connection of the second conductive layer and the capacitor plate is lower than the resistance of the capacitor plate itself. Therefore, compared to the layout of the semiconductor structure without the second conductive layer pattern, the resistance of the semiconductor structure corresponding to the layout added the second conductive layer pattern is low, thereby avoiding the problem of affecting the performance due to the high resistance and improving the performance of the semiconductor structure.

As shown in Fig. 4, in a specific embodiment of the disclosure, the semiconductor structure further includes a first contact via pattern 400, which is between the capacitor plate pattern 300 and the second conductive layer pattern 500. Specifically, the first contact via pattern 400 is on the capacitor plate pattern 300, and the second conductive layer pattern 500 is overlaid on the first contact via pattern 400. In this way, when the semiconductor structure corresponding to the layout is used, the corresponding first contact via pattern forms a first contact via, and the first contact via is connected with the capacitor plate 30 and the second conductive layer 50, as shown in Fig. 1. The second conductive layer 50 and the capacitor plate 30 can be more conveniently connected through the first contact via 40. The equivalent circuit diagram of the structure is shown in Fig. 2. It can be seen from Fig. 2 that the resistance of the part formed by the capacitor plate 30, the second conductive layer 50 and the first contact via 40 meets Rₜₒₜₐₗ=R_{CT+M1}//R_{TCP}, and R_{TCP} is the resistance of the capacitor plate 30, R_{CT+M1} is the resistance of the second conductive layer 50 and the first contact via 40, and Rₜₒₜₐₗ is the equivalent resistance of the capacitor plate 30 and the second conductive layer 50 connected in parallel. Therefore, compared to the layout of the semiconductor structure without the second conductive layer pattern 500, the layout makes the resistance in the corresponding semiconductor structure is still low.

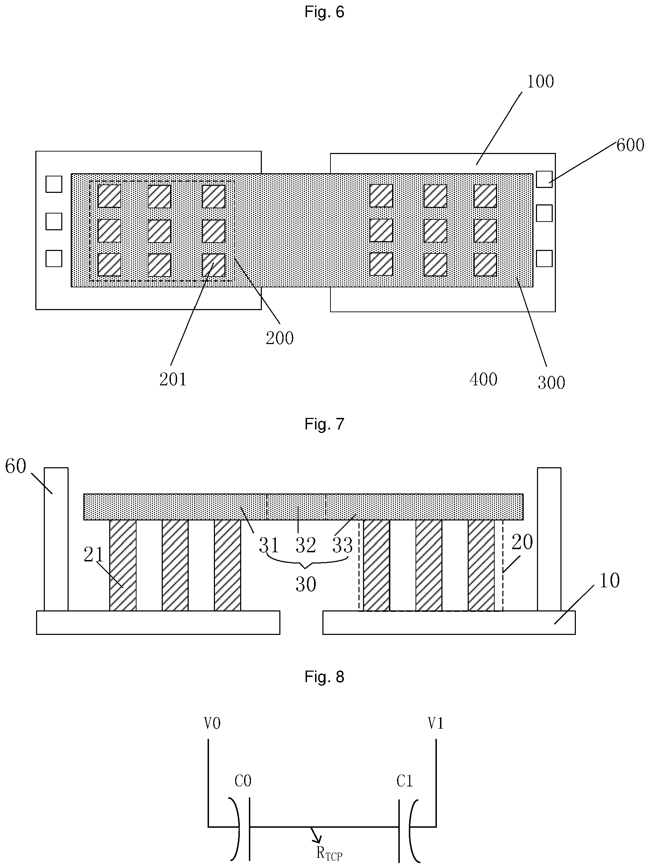

It is to be noted that in order to display each pattern, so that those skilled in the art can more clearly know the position of each pattern, Fig. 4 and Fig. 6 of the disclosure are actually perspectives of the layout, that is, some patterns that have actually been covered by other patterns are also shown. In Fig. 4, the capacitor bank pattern 200 that has been covered by the capacitor plate pattern 300 is shown, and the first contact via pattern 400 that has been covered by the second conductive layer pattern 500 is also shown. In Fig. 6, the capacitor bank pattern 200 that has actually been covered by the capacitor plate pattern 300 is shown.

Specifically, the number of the first contact via patterns 400 can be set according to the area of the second conductive layer pattern 500, etc. There can be a plurality of the first contact vias or one first contact via. For example, when the area of the second conductive layer pattern 500 is large, the number of the first contact via patterns 400 can be set to be larger; when the area of the second conductive layer pattern 500 is small, the number of the first contact via patterns 400 can be set to be smaller correspondingly. The larger the number of the first contact via patterns, the lower the overall equivalent resistance, and the lower the equivalent resistance of the capacitor plate 30 and the second conductive layer 50 connected in parallel.

In order to better connect the second conductive layer 50 and the capacitor plate 30 in the corresponding semiconductor structure, and stably support the second conductive layer 50, as shown in Fig. 4, in a specific embodiment of the disclosure, there are a plurality of the first contact via patterns 400, and the plurality of the first contact via patterns 400 are spaced.

There can be one second conductive layer pattern 500, as shown in Fig. 4; in this case, the area of the second conductive layer pattern 500 is approximately equal to that of the capacitor plate pattern 300 (the area of the second conductive layer pattern is slightly smaller).

Of course, there can be a plurality of the second conductive layer patterns 500. In an embodiment of the disclosure, there are a plurality of the second conductive layer patterns, and the plurality of the second conductive layer patterns are spaced. In this case, the sum of the areas of all the second conductive layer patterns can be approximately equal to the area of the capacitor plate pattern 300.

The capacitor in the semiconductor structure corresponding to the layout of the disclosure includes a lower electrode layer. The lower electrode layer can include conductive compounds formed by one or two of metal nitrides and metal silicides, such as Titanium Nitride, Titanium Silicide, Nickel Silicide, and TiSixNy. In a specific embodiment of the disclosure, the lower electrode layer can include a titanium nitride layer formed by ALD.

The capacitor in the semiconductor structure corresponding to the layout of the disclosure includes a capacitance dielectric layer. The capacitance dielectric layer can be a high K dielectric layer, so as to improve the capacitance value per unit area, and can include a layer stack formed by nitrides or one of ZrOx, HfOx, ZrTiOx, RuOx, SbOx and AlOx or more than two of the group of the above materials. The capacitor in the semiconductor structure corresponding to the layout of the disclosure includes an upper electrode layer. The upper electrode layer can include compounds formed by one or two of metal nitrides and metal silicides, such as Titanium Nitride, Titanium Silicide, Nickel Silicide, and TiSixNy. In a specific embodiment, the upper electrode layer include a titanium nitride layer formed by ALD. It is also to be noted that the materials of the second conductive layer pattern and the first conductive layer in the semiconductor structure corresponding to the layout of the disclosure can include, but are not limited to, wolfram (W), cuprum (Cu), nickel (Ni), aurum (Au) or argentum (Ag), etc. The materials of the second conductive layer and the first conductive layer can be the same or different, and those skilled in the art can choose the suitable material according to the actual situation.

The capacitor plate in the semiconductor structure corresponding to the layout of the disclosure is a conductive layer, which can include conductive materials and semiconductor materials, such as Si and/or Ge. Suitable materials can be selected according to the actual situation to form the capacitor plate of the disclosure.

In a specific embodiment, as shown in Fig. 4, the layout of the disclosure also includes a second contact via pattern 600, which is on the first conductive layer pattern 100 and outside a predetermined area of the capacitor plate pattern. The predetermined area is an area, in which the capacitor bank pattern 200 is set, of the first conductive layer pattern 100. Correspondingly, the material of the second contact via formed by the second contact via pattern is conductive material, which can be selected according to the actual situation, including but not limited to wolfram (W), cuprum (Cu), nickel (Ni), aurum (Au) or argentum (Ag), etc. In another embodiment of the disclosure, there are a plurality of the second contact via patterns 600.

In another typical embodiment of the disclosure, a semiconductor device is also provided, which can include the above semiconductor structure; or a layout of the semiconductor device include any one of the above layout of the semiconductor structures. The above description can be referred to the specific semiconductor structure and the layout of the semiconductor structure, and elaborations are omitted herein.

The above semiconductor device includes the above semiconductor structure. In the semiconductor structure, the second conductive layer 50 is formed above the capacitor plate 30, and the second conductive layer 50 is connected with the capacitor plate 30, so that in the semiconductor structure, the second conductive layer 50 is equivalent to being connected in parallel at two ends of the capacitor plate 30, that is, the second conductive layer 50 is connected with the capacitor plate 30 in parallel, and the resistance formed by the parallel connection of the second conductive layer and the capacitor plate is lower than the resistance of the capacitor plate 30 itself. Therefore, compared to the semiconductor structure without the second conductive layer 50, the resistance of the semiconductor structure with the second conductive layer 50 is low, thereby avoiding the problem of affecting the performance due to the high resistance and improving the performance of the semiconductor device.

In a specific embodiment, the semiconductor device is a semiconductor memory. The semiconductor memory structure further includes a transistor structure. Each of a memory cell usually includes a capacitor bank 20 and a transistor. A gate of the transistor is connected with a word line, a drain of the transistor is connected with a bit line, and a source of the transistor is connected with the capacitor bank 20. A voltage signal of the word line can control the transistor on or off, and then data information stored in the capacitor bank 20 is read through the bit line, or the data information is written to the capacitor bank 20 through the bit line for storage.

In another embodiment of the disclosure, the above semiconductor device is a charge pump. The circuit diagram of the charge pump is shown in Fig. 5. The charge pump includes the above semiconductor structure, and for including the above semiconductor structure, its resistance is lower and less power is consumed, so that the pump efficiency of the charge pump is improved.

Of course, the semiconductor device of the disclosure is not limited to the semiconductor memory or the charge pump, but can also be any other device including the semiconductor structure, that is, those skilled in the art in the field can apply the semiconductor structure in any device needing it.

In order to make those skilled in the art more clearly understand the technical solutions of the disclosure, elaborations will be given below in combination with specific embodiments.

### Embodiment

As shown in Fig. 1, the semiconductor structure is formed by a plurality of first conductive layers 10, a plurality of capacitor banks 20, a capacitor plate 30, a plurality of first contact vias 40 and a second conductive layer 50. The plurality of first conductive layers 10 are set intervals. A plurality of the capacitor banks 20 are on the first conductive layers 10 in one-to-one correspondence. Each capacitor 21 includes a lower electrode layer, a capacitance dielectric layer and an upper electrode layer stacked from bottom to top. The capacitor plate 30 is on each upper electrode layer. The second conductive layer 50 is above the capacitor plate 30 and connected with the capacitor plate 30 through the plurality of the first contact vias 40.

The capacitor plate 30 is formed by a first part 31, a second part 32 and a third part 33. The projection of the first part 31 on the first conductive layers 10 is located on one of two adjacent first conductive layers 10, the projection of the third part 33 on the first conductive layers 10 is located on the other of the two adjacent first conductive layers 10, and the second part 32 is between the first part 31 and the second part 32. There are the plurality of the first contact vias 40 which are evenly distributed formed on the first part 31 and the third part 33.

The second conductive layer 50 is connected with each of the plurality of the first contact vias 40, and the projection of the second conductive layer 50 on the first conductive layers 10 can be located in the projection of the capacitor plate 30 on the first conductive layers 10.

The equivalent circuit structure of the structure shown in Fig. 1 is shown in Fig. 2, correspondingly, the equivalent resistance of the part in Fig. 1 meets Rₜₒₜₐₗ₁=R_{CT+M1}//R_{TCP}, and R_{CT+M1} is the resistance value of the second conductive layer 50 and the first contact via 40 connected in series, and R_{TCP} is the resistance of the capacitor plate 30.

### Comparison Embodiment

Unlike the embodiment, the semiconductor structure does not include the second conductive layer 50 and the first contact via 40. Its layout is shown in Fig. 6, its structure is shown in Fig. 7, and its equivalent circuit structure is shown in Fig. 8. The equivalent resistance of the part in Fig. 7 meets Rₜₒₜₐₗ₂=R_{TCP}, and R_{TCP} is the resistance of the capacitor plate 30.

It can be known from the comparison of the equivalent resistance in the above embodiment and comparison embodiment, the resistance of the semiconductor structure is reduced due to adding the first contact via 40 and the second conductive layer 50 in the embodiment.

It can be seen from above description that the above embodiments of the disclosure achieve the following technical effects.
1) In the semiconductor structure of the disclosure, the second conductive layer is formed above the capacitor plate, and the second conductive layer is connected with the capacitor plate, so that in the semiconductor structure, the second conductive layer is equivalent to being connected in parallel at two ends of the capacitor plate, that is, the second conductive layer is connected with the capacitor plate in parallel, and the resistance formed by the parallel connection of the second conductive layer and the capacitor plate is lower than the resistance of the capacitor plate itself. Therefore, compared to the semiconductor structure without the second conductive layer, the resistance of the semiconductor structure with the second conductive layer is low, thereby avoiding the problem of affecting the performance due to the high resistance and improving the performance of the semiconductor structure.
2) The semiconductor device of the disclosure includes the semiconductor structure. In the semiconductor structure, the second conductive layer is formed above the capacitor plate, and the second conductive layer is connected with the capacitor plate, so that in the semiconductor structure, the second conductive layer is equivalent to being connected in parallel at two ends of the capacitor plate, that is, the second conductive layer is connected with the capacitor plate in parallel, and the resistance formed by the parallel connection of the second conductive layer and the capacitor plate is lower than the resistance of the capacitor plate itself. Therefore, compared to the semiconductor structure without the second conductive layer, the resistance of the semiconductor structure with the second conductive layer is low, thereby avoiding the problem of affecting the performance due to the high resistance and improving the performance of the semiconductor device.
3) In the layout of the semiconductor structure of the disclosure, the second conductive pattern is on the capacitor plate pattern, so that the second conductive layer is formed correspondingly on the capacitor plate in the semiconductor structure corresponding to the layout, that is, the second conductive layer connected with the capacitor plate is formed; the second conductive layer is equivalent to being connected in parallel at two ends of the capacitor plate, that is, the second conductive layer is connected with the capacitor plate in parallel, and the resistance formed by the parallel connection of the second conductive layer and the capacitor plate is lower than the resistance of the capacitor plate itself. Therefore, compared to the layout of the semiconductor structure without the second conductive layer pattern, the resistance of the semiconductor structure corresponding to the layout added the second conductive layer pattern is low, thereby avoiding the problem of affecting the performance due to the high resistance and improving the performance of the semiconductor structure.

The above is only the preferred embodiments of the disclosure and not intended to limit the disclosure; for those skilled in the art, the disclosure can have various modifications and changes. Any modifications, equivalent replacements, improvements and the like within the spirit and principle of the disclosure should fall within the protection scope of the claims of the disclosure.

## Claims

1. A semiconductor structure, comprising:
a plurality of first conductive layers that are spaced;
a plurality of capacitor banks, and the capacitor bank being on the first conductive layer in one-to-one correspondence and the capacitor bank comprising at least a capacitor, each capacitor comprising a lower electrode layer, a capacitance dielectric layer and an upper electrode layer stacked from bottom to top;
a capacitor plate, wherein the capacitor plate is on each upper electrode layer; and
a second conductive layer, wherein the second conductive layer is above the capacitor plate and connected with the capacitor plate.

2. The semiconductor structure according to claim 1, the semiconductor structure further comprises:
a first contact via, wherein the first contact via is between the capacitor plate and the second conductive layer, and is configured to connect the capacitor plate and the second conductive layer.

3. The semiconductor structure according to claim 2, wherein there are a plurality of the first contact vias, and the plurality of the first contact vias are set intervals.

4. The semiconductor structure according to claim 1, wherein each of the plurality of the capacitor banks comprises a plurality of capacitors.

5. The semiconductor structure according to claim 1, the semiconductor structure further comprises:
a second contact via, wherein the second contact via is on the first conductive layer and outside a predetermined area, the predetermined area being an area, in which the capacitor bank is set, of the first conductive layer.

6. The semiconductor structure according to claim 5, wherein there are a plurality of the second contact vias.

7. The semiconductor structure according to claim 5, wherein the first conductive layer and the second conductive layer are metal layer, or the first conductive layer or the second conductive layer is the metal layer.

8. A layout of a semiconductor structure, comprising:
a plurality of first conductive layer patterns that are set intervals;
a plurality of capacitor bank patterns, and the capacitor bank pattern being on the first conductive layer pattern in one-to-one correspondence, the capacitor bank pattern comprising at least a capacitor pattern;
a capacitor plate pattern, wherein the capacitor plate pattern is overlaid on each of the plurality of the capacitor bank patterns; and
a second conductive layer pattern, wherein the second conductive layer pattern is overlaid on at least a part of the capacitor plate pattern.

9. The layout according to claim 8, the layout further comprises:
a first contact via pattern, wherein the first contact via pattern is on the capacitor plate pattern;
the second conductive layer pattern overlays on the first contact via pattern.

10. The layout according to claim 9, wherein there are a plurality of the first contact via patterns that are set intervals, and the second conductive layer pattern is overlaid on all of the plurality of the first contact via patterns.

11. The layout according to claim 8, the layout further comprises:
a second contact via pattern, wherein the second contact via pattern is on the first conductive layer pattern and outside a predetermined area, the predetermined area being an area, in which the capacitor bank pattern is set, of the first conductive layer pattern.

12. The layout according to claim 11, wherein there are a plurality of the second contact via patterns.

13. The layout according to claim 8, wherein the capacitor bank pattern comprises a plurality of the capacitor patterns.

14. A semiconductor device, comprising the semiconductor structure according to any one of claims 1 to 7, or a layout of the semiconductor device comprises the layout of the semiconductor structure according to any one of claims 8 to 13.

15. The semiconductor device according to claim 14, wherein the semiconductor device is a semiconductor memory.
